# EUROPÄISCHE PATENTANMELDUNG

(11) **EP 4 727 274 A1**
(43) Veröffentlichungstag der Anmeldung: **15.04.2026**
(21) Anmeldenummer: 24205450.0
(22) Anmeldetag: 09.10.2024
(51) Int. Cl.: H05K 7/14

(54) **INTERAKTIONSMODUL FÜR EIN SCHALTSCHRANKLOSES AUTOMATISIERUNGSSYSTEM EINER INDUSTRIEANLAGE**

(71) Anmelder: Murrelektronik GmbH, 71570 Oppenweiler (DE)
(72) Erfinder: Prein, Olaf, 71570 Oppenweiler (DE); Aumüller, Jan, 71570 Oppenweiler (DE)
(74) Vertreter: Prinz & Partner mbB

(57) **Zusammenfassung**

Die Erfindung betrifft ein Interaktionsmodul (16) für ein schaltschrankloses Automatisierungssystem (10) einer Industrieanlage. Das Interaktionsmodul (16) umfasst ein Gehäuse (30) und eine Steckverbindungskomponente (20) zur elektrischen und/oder mechanischen Anbindung an eine Basis (12) des schaltschranklosen Automatisierungssystems (10). Ferner weist das Interaktionsmodul (16) ein Ausgabeelement (40) auf, das im oder am Gehäuse (30) angeordnet und dazu ausgebildet ist, ein optisches und/oder akustisches Signal auszugeben, das einen Status der Industrieanlage signalisiert. Alternativ oder zusätzlich weist das Interaktionsmodul (16) ein Eingabeelement (62) auf, das im oder am Gehäuse (30) angeordnet ist und worüber eine Eingabe zur Steuerung der Industrieanlage erfolgen kann. Ferner betrifft die Erfindung ein schaltschrankloses Automatisierungssystem (10).

## Beschreibung

Die Erfindung betrifft ein Interaktionsmodul für ein schaltschrankloses Automatisierungssystem einer Industrieanlage. Ferner betrifft die Erfindung ein schaltschrankloses Automatisierungssystem.

Viele Industrieanlagen weisen einen Schaltschrank auf, in dem sich die zentralen Steuerungselemente zur Anlagensteuerung befinden.

Insbesondere bei modernen Anlagen werden die Funktionen des Schaltschranks jedoch zunehmend in das Feld verlegt. In den letzten Jahren hat sich die Technologie derart weiterentwickelt, dass es möglich ist, ganze Anlagen mit modularen schaltschranklosen Automatisierungssystemen zu steuern.

Die bekannten schaltschranklosen Automatisierungssysteme sind meist mit mehreren Funktions- und/oder Versorgungsmodulen bestückt, die über die Anlage verteilt angeordnet sind und jeweils unterschiedliche Aufgaben wahrnehmen und/oder unterschiedliche Teile der Anlage steuern.

Der Aufbau und die Wartung moderner schaltschrankloser Automatisierungssysteme ist jedoch häufig komplex und verglichen mit konventionellen schaltschrankbasierten Systemen mit einem gesteigerten Aufwand und höheren Kosten verbunden. Auch ist der Einsatz moderner schaltschrankloser Automatisierungssysteme häufig auf einfache Steuerungsaufgaben beschränkt.

Die Aufgabe der Erfindung ist es daher, die Nachteile der aus dem Stand der Technik bekannten schaltschrankloser Automatisierungssysteme zu beheben.

Die Aufgabe wird erfindungsgemäß gelöst durch ein Interaktionsmodul für ein schaltschrankloses Automatisierungssystem einer Industrieanlage, umfassend ein Gehäuse und eine Steckverbindungskomponente zur elektrischen und/oder mechanischen Anbindung an eine Basis des schaltschranklosen Automatisierungssystems. Das Interaktionsmodul weist ein Ausgabeelement auf, das im oder am Gehäuse angeordnet und dazu ausgebildet ist, ein optisches und/oder akustisches Signal auszugeben, das einen Status der Industrieanlage signalisiert. Alternativ oder zusätzlich weist das schaltschranklose Interaktionsmodul außerdem ein Eingabeelement auf, das im oder am Gehäuse angeordnet ist und worüber eine Eingabe zur Steuerung der Industrieanlage erfolgen kann.

Durch das Ausgabeelement und/oder Eingabeelement können zusätzliche Funktionen in das schaltschranklose Automatisierungssystem integriert werden, insbesondere Anzeige- sowie Bedienfunktionen für das Anlagen- und/oder Wartungspersonal.

Mit anderen Worten kann durch den Einsatz des erfindungsgemäßen Interaktionsmoduls also das Anwendungsspektrum von Automatisierungssystemen erweitert werden, insbesondere von schaltschranklosen Automatisierungssystemen. Neben Funktions- und Versorgungsmodulen können Dank des erfindungsgemäßen Interaktionsmoduls zudem Bedienfunktionen, durch die das Anlagenpersonal mit der Industrieanlage interagieren kann, und Signalisierungsfunktionen für das Anlagenpersonal vorgesehen werden. Diese zusätzlichen Funktionen können zudem in einem einzigen Bauteil vereint werden, wodurch wiederum Hardware und Kosten eingespart werden können.

Das Gehäuse ist beispielsweise aus einem Gehäusekörper und einem Gehäusedeckel gebildet. Das Ausgabeelement und/oder das Eingabeelement kann bzw. können im oder am Gehäusedeckel angeordnet sein. Die Steckverbindungskomponente ist beispielsweise am Gehäusekörper angeordnet, insbesondere an einer vom Gehäusedeckel wegweisenden Seite. Durch diesen Aufbau ist das gesamte Interaktionsmodul schnell und technisch vergleichsweise einfach austauschbar. Gleichzeitig ist durch die Anordnung des Ausgabeelements und/oder des Eingabeelements am Gehäusedeckel eine gute Zugänglichkeit für das Anlagenpersonal sichergestellt.

Der Gehäusedeckel ist insbesondere auf den Gehäusekörper aufgesteckt und/oder am Gehäusekörper mit einem Befestigungsmittel befestigt. Das Ausgabeelement und/oder das Eingabeelement wiederum können durch einen Steckkontakt und/oder eine Flachbandleitung mit einer im Gehäuse aufgenommenen Leiterplatte und/oder Elektronik verbunden sein. Dieser Aufbau ist technisch einfach realisierbar und ermöglicht bei Bedarf einen besonders einfachen Austausch des Gehäusedeckels mitsamt dem Ausgabeelement und/oder Eingabeelement.

In einer Ausführungsvariante des Interaktionsmoduls umfasst das Ausgabeelement zumindest eine Signalleuchte, die dazu ausgebildet ist, einen Betriebsstatus, eine Produktionsanweisung, einen Sicherheitshinweis und/oder einen Alarm für Arbeiter der Industrieanlage auszugeben, insbesondere optisch zu signalisieren. Mit anderen Worten gibt das Ausgabeelement, das die zumindest eine Signalleuchte umfasst, ein optisches Signal aus.

Die Signalleuchte kann einfarbig oder mehrfarbig ausgeführt sein. Außerdem kann die Signalleuchte dazu ausgebildet sein, ein Dauerlicht und/oder Blinklicht als Signal auszugeben.

Vereinfacht ausgedrückt können mittels der Signalleuchte des Interaktionsmoduls Funktionen konventioneller Informations- oder Warnleuchten abgebildet werden. Auf den Einsatz und die oft komplexe Anbindung von als eigenständige Bauteile ausgebildeten Informations- oder Warnleuchten an das Automatisierungssystem kann somit verzichtet werden.

Die Signalleuchte ist beispielsweise eine Flächenleuchte, die sich über einen Teil einer Seite des Gehäuses erstreckt, insbesondere über zumindest 20 %, beispielweise über mehr als 50 %, z.B. über mehr als 80 % der Seitenfläche. Dadurch wird eine gute Sichtbarkeit und somit Informationszugänglichkeit für das Anlagenpersonal sichergestellt, selbst wenn sich dieses nicht in unmittelbarer Nähe zum Interaktionsmodul befindet.

In einer weiteren Ausführungsvariante des Interaktionsmoduls ist ein Teil des Gehäuses transparent oder transluzent ausgebildet, sodass Licht der Signalleuchte über den Teil des Gehäuses aus dem Gehäuse auskoppeln kann. Demnach kann die Signalleuchte innerhalb des Gehäuses angeordnet sein und trotzdem Lichtsignale in die Umgebung aussenden. Es ist zum Aussenden von Lichtsignalen also nicht notwendig, Gehäusedurchbrüche vorzusehen. Die Signalleuchte ist demnach geschützt aufgenommen und das gesamte Interaktionsmodul kann ein geschlossenes bzw. abgedichtetes Gehäuse aufweisen, wodurch es vielseitig einsetzbar ist, insbesondere auch in Umgebungen, die höhere Anforderung an die Schutzklasse haben, beispielsweise IP65 oder IP67.

Das Interaktionsmodul kann auch mehrere Signalleuchten umfassen, die an unterschiedlichen Seiten des Gehäuses angeordnet sind, sodass die Signalleuchten Licht in unterschiedliche Raumrichtungen ausstrahlen können. Da die Signale in mehrere Raumrichtungen ausgegeben werden können, lässt sich der Empfängerkreis vergrößern, wodurch sichergestellt ist, dass die Signale wahrgenommen werden.

Es ist ferner denkbar, dass das Ausgabeelement zumindest ein Display umfasst, das dazu ausgebildet ist, zur Signalausgabe zumindest ein Symbol anzuzeigen. Durch das Display können eine Vielzahl verschiedener Informationen und/oder Anweisungen ausgegeben werden. Insbesondere kann über das Display auch eine Handlungsanweisung ausgegeben werden, die das Anlagenpersonal zu befolgen hat.

Das Display ist beispielsweise eine auf Elektrophorese basierende Anzeige. Insbesondere kann es als elektronisches Papier ausgebildet sein. Hierbei handelt es sich um eine Art einer bistabilen Anzeige, die ein Bild ohne Strom speichern kann und nur zur Veränderung des Anzeigezustands Energie benötigt. Anzeigen dieser Art sind auch unter den Begriffen e-paper, E-Paper, ePaper, E-Ink, P-Ink sowie unter weiteren Namen bekannt. Ferner ist denkbar, dass das Display als eine bistabile LCD-Anzeige ausgebildet ist und/oder basierend auf dem Prinzip der mikromechanisch gesteuerten Interferenzmodulation arbeitet.

Die Ausgestaltung des Displays als elektronisches Papier hat den Vorteil, dass auch im stromlosen Zustand zur Signalausgabe Informationen angezeigt werden können. Insbesondere ist es daher möglich, eine Handlungsanweisung darzustellen, die dem Anlagenpersonal noch zur Verfügung steht, selbst wenn die Industrieanlage aufgrund eines Defekts (zumindest teilweise) von der Stromversorgung abgetrennt wurde.

Es kann auch vorgesehen sein, dass das Display eine Hinterleuchtung umfasst, insbesondere wobei eine Lichtfarbe der Hinterleuchtung zur Ausgabe des optischen Signals veränderbar ist. Dadurch kann das Display selbst als Informations- oder Warnleuchte genutzt werden, beispielsweise um weiter vom Interaktionsmodul entfernte Personen mittels der Farbe bestimmte Anlagenbetriebszustände mitzuteilen und/oder sie zu warnen.

Grundsätzlich können als Farben die für Industrieanlagen typischen Signalfarben verwendet werden, also rot, gelb, orange, grün, blau, weiß, und magenta. Über die unterschiedlichen Farben kann dem Anlagenpersonal also direkt eine entsprechende Information angezeigt werden, insbesondere hinsichtlich des Zustands der Industrieanlage.

Das Display kann ferner als Touch-Display bzw. Touchscreen ausgebildet sein. Dies hat den Vorteil, dass Bedienelemente grafisch dargestellt und situationsbedingt verändert werden können. In diesem Zusammenhang ist auch denkbar, dass das Display über Mittel verfügt, die Anzeige- und/oder Ausgabeeinstellungen zu verändern. Beispielsweise kann ein Sprachpaket vorgesehen sein, mit dem die Sprache angezeigter Bedienelemente verändert werden kann.

Das Eingabeelement ist beispielsweise ein manuell zu betätigendes Eingabeelement. Es kann mit mehreren weiteren Eingabeelementen auf einer Leiterplatte angeordnet sein, wobei die Eingabeelemente durch einen Bus als Matrix oder direkt mit einer vorzugsweise im Gehäuse angeordneten Elektronik verbunden sind. Dieser Aufbau ist technisch einfach realisierbar.

Die Aufgabe der Erfindung wird ferner gelöst durch ein schaltschrankloses Automatisierungssystem für eine Industrieanlage, umfassend eine Basis und zumindest ein erfindungsgemäßes Interaktionsmodul, wobei das Interaktionsmodul über die Steckverbindungskomponente mit der Basis elektrisch und/oder mechanisch verbunden ist. Die Vorteile, die vorstehend zum erfindungsgemäßen Interaktionsmodul diskutiert wurden, gelten für das schaltschranklose Automatisierungssystem in gleicher Weise.

In einer Variante des schaltschranklosen Automatisierungssystems ist die Basis als eine Steckplatte zur Aufnahme des Interaktionsmoduls sowie weiterer steckbarer Module ausgebildet. Dies ermöglicht eine besonders einfache Integration weiterer Module und/oder den Austausch bestehender Module. Bei den Modulen kann es sich, wie vorstehend schon erläutert, um Funktions- und/oder Versorgungsmodule handeln.

Es kann vorgesehen sein, dass die Basis mehrere Kommunikationsleitungen sowie Leiter zum Führen einer Niederspannung und/oder Leiter zum Führen einer Kleinspannung aufweist und dass die Steckverbindungskomponente dazu ausgebildet ist, eine Datenverbindung zwischen dem Interaktionsmodul und den Kommunikationsleitungen der Basis herzustellen und/oder eine elektrische Verbindung zu den klein- und/oder niederspannungsführenden Leitern der Basis herzustellen, wenn das Interaktionsmodul auf die Basis aufgesteckt bzw. in die Basis eingesteckt ist.

Von einer Niederspannung spricht man bei einer Wechselspannung von 1.000 V oder weniger, insbesondere zwischen 50 V und 1.000 V, bzw. einer Gleichspannung von 1.500 V oder weniger, insbesondere zwischen 75 V und 1.500 V. Dagegen spricht man von einer Kleinspannung bei einer Wechselspannung von 50 V oder weniger bzw. einer Gleichspannung von 120 V oder weniger, insbesondere 75 V und weniger.

Die Leiter zum Führen einer Niederspannung sind insbesondere ausgelegt, eine Wechselspannung von 110 V, 230 V oder 400 V bzw. eine Gleichspannung im Bereich von 400 V bis 800 V zu führen.

Die Leiter zum Führen einer Kleinspannung sind insbesondere ausgelegt, eine Gleichspannung von 24 V oder 48 V zu führen.

Durch die Leiter zum Führen einer Niederspannung und/oder Leiter zum Führen einer Kleinspannung kann das Interaktionsmodul mit Energie versorgt werden. Insbesondere kann die Energieversorgung des Interaktionsmoduls auch ausschließlich durch eine Kleinspannung und die dafür vorgesehenen Leiter erfolgen. Dies hat den Vorteil, dass auf einen zusätzlichen Schutz gegen Berühren verzichtet werden kann.

Sowohl die Energieversorgung des Interaktionsmoduls als auch Datenverbindungen zu weiteren Modulen und/oder externen Systemen können durch einfaches Aufstecken des Interaktionsmoduls auf die Basis hergestellt werden.

In einer weiteren Variante weist das schaltschranklose Automatisierungssystem zumindest ein zusätzliches erfindungsgemäßes Interaktionsmodul auf. Es sind also insgesamt mindestens zwei Interaktionsmodule vorgesehen.

Die beiden Interaktionsmodule können an entgegengesetzten Enden der Basis angeordnet sein und insbesondere jeweils äußerste Module einer entlang der Basis angeordneten Reihe von Modulen bilden.

Dadurch können Signale mittels der Ausgabeelemente der jeweiligen Interaktionsmodule in entgegengesetzte Raumrichtungen ausgegeben werden, was wiederum die Signalzugänglichkeit insgesamt verbessert. Vereinfacht ausgedrückt ist durch die Signalausgabe in entgegengesetzte Richtungen eine größere Anzahl potenzieller Empfänger erreichbar. Insbesondere ist man hierdurch auch unabhängiger von einer Einbausituation am Anwendungsort.

In einer weiteren Ausführungsform umfasst das schaltschranklose Automatisierungssystem zumindest eine weitere Basis mit einem erfindungsgemäßen Interaktionsmodul. Es sind also mindestens zwei Basen vorgesehen, die jeweils mindestens ein Interaktionsmodul umfassen.

Um die Signalzugänglichkeit weiter zu verbessern und/oder den Empfängerhorizont weiter zu vergrößern, kann vorgesehen sein, dass die Basen voneinander beabstandet angeordnet und über einen Datenanschluss miteinander gekoppelt sind, sodass mittels der auf den verschiedenen Basen angeordneten Interaktionsmodulen voneinander abhängige und/oder aufeinander abgestimmte optische und/oder akustische Signale an unterschiedlichen Positionen der Industrieanlage ausgegeben werden können.

Es kann auch vorgesehen sein, dass das Interaktionsmodul einer Basis einen Lichtsensor aufweist oder ein Lichtsensormodul mit einem Lichtsensor bei der Basis vorhanden ist, wobei der Lichtsensor eingerichtet ist, das optische Signal des Interaktionsmoduls der anderen Basis zu empfangen. Hierüber lässt sich eine Kommunikation zwischen den Basen ermöglichen, ohne dass eine separate Datenverbindung notwendig ist, insbesondere weder eine leitungsgebundene Anbindung noch eine kabellose Datenverbindung wie WLAN oder ähnliches. Die Kommunikation zwischen den Basen basiert demnach (ausschließlich) auf den optischen Signalen.

Weitere Merkmale und Vorteile der Erfindung ergeben sich aus der nachfolgenden Beschreibung sowie aus den beigefügten Zeichnungen, auf die Bezug genommen wird. In den Zeichnungen zeigen:
- Figur 1 eine schematische Darstellung eines erfindungsgemäßen schaltschranklosen Automatisierungssystems in einer ersten Ausführungsform;
- Figur 2 eine schematische Darstellung eines erfindungsgemäßen schaltschranklosen Automatisierungssystems in einer zweiten Ausführungsform; und
- Figur 3 eine schematische Darstellung eines erfindungsgemäßen schaltschranklosen Automatisierungssystems in einer dritten Ausführungsform.

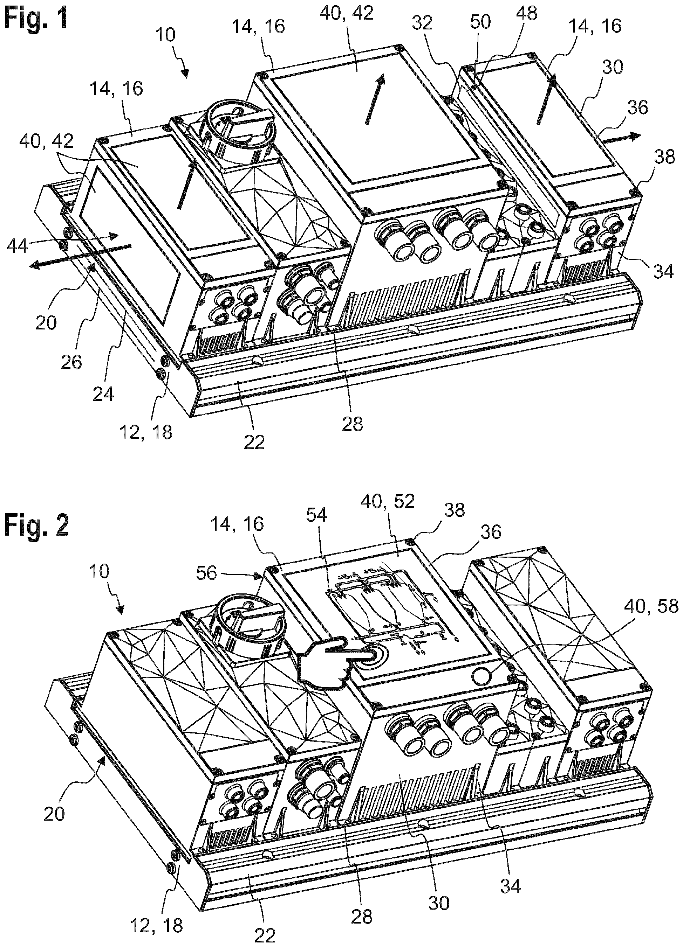

Figur 1 zeigt schematisch ein Ausführungsbeispiel eines erfindungsgemäßen schaltschranklosen Automatisierungssystems 10 für eine Industrieanlage.

Das schaltschranklose Automatisierungssystem 10 umfasst eine Basis 12 und sechs entlang der Basis 12 in einer Reihe angeordnete Module 14. Drei der sechs Module 14 sind erfindungsgemäße Interaktionsmodule 16. Bei den anderen Modulen 14 handelt es sich beispielsweise um ein Funktionsmodul sowie um ein Versorgungsmodul.

Im Ausführungsbeispiel sind die erfindungsgemäßen Interaktionsmodule 16 in der Mitte sowie an den Enden der in Reihe angeordnete Module 14 vorgesehen. Die Reihe erstreckt sich vorliegend über die gesamte Länge der Basis 12, sodass die die Reihe abschließenden Interaktionsmodule 16 an entgegengesetzten Enden der Basis 12 angeordnet sind. Grundsätzlich kann es aber auch vorgesehen sein, dass die Basis 12 noch freie Plätze aufweist, sodass die Basis 12 um Module 14 erweiterbar ist.

Die Basis 12 ist in der dargestellten Variante als eine Steckplatte 18 ausgebildet.

Die Module 14, insbesondere die Interaktionsmodule 16, weisen jeweils zumindest eine Steckverbindungskomponente 20 auf, mittels der sie mechanisch und elektrisch mit der Basis 12 verbunden sind. Dies erfolgt in einfacher Weise dadurch, dass die Module 14 über ihre jeweilige Steckverbindungskomponente 20 in die Basis 12 eingesteckt werden, also auf einen freien Steckplatz der Steckplatte 18.

Mechanisch verbunden bedeutet in diesem Zusammenhang, dass die Interaktionsmodule 16 mittels ihrer Steckverbindungskomponenten 20 jeweils fest an der Basis 12 fixiert sind. Ein versehentliches Lösen der Module 14, insbesondere der Interaktionsmodule 16, ist demnach nicht möglich.

In Figur 1 sind alle Module 14 mit der Basis 12 durch Steckverbindungen verbunden, die durch die jeweiligen Steckverbindungskomponenten 20 der Module 14 sowie entsprechende Eingriffsgeometrien der Basis 12 gebildet sind. Die Steckverbindungen sind beispielsweise durch ineinandergreifende Zapfen und Löcher in den jeweiligen Gegenstücken realisiert. Mit anderen Worten können die Steckverbindungskomponenten 20 also als Zapfen und/oder Löcher ausgebildet sein.

Alternativ oder zusätzlich ist auch möglich, dass die Basis 12 einen Rahmen 22 aufweist, in welchen die Module 14 eingesetzt bzw. eingesteckt sind. Die Module 14 können dabei aneinanderliegend angeordnet sein, um sich gegenseitig zu stabilisieren. Alternativ kann aber auch ein Abstand zwischen den einzelnen Modulen 14 vorgesehen sein, insbesondere um eine Wärmeabführung der einzelnen Module 14 zu verbessern. Auch solche Verbindungen sind grundsätzlich als Steckverbindungen im Sinne der Erfindung zu verstehen. Die Steckverbindungskomponenten 20 der Interaktionsmodule 16 können in diesen Fällen durch die dreidimensionale Form der Interaktionsmodule 16 selbst gebildet sein.

Auch lassen sich die Steckverbindungen über Buchsen und Steckverbinder realisieren, die gleichzeitig die mechanische Anbindung und elektrische Verbindung sicherstellen.

Selbstverständlich ist die Art der Steckverbindung nicht einschränkend zu verstehen. Viele anderen Steckverbindungstypen sind denkbar.

Die Basis 12 weist im Ausführungsbeispiel mehrere Kommunikationsleitungen 24 sowie elektrische Leiter 26 zum Führen einer Kleinspannung auf.

Die Steckverbindungskomponenten 20 der jeweiligen Interaktionsmodule 16 sind im Ausführungsbeispiel dazu ausgebildet, Datenverbindungen der Interaktionsmodule 16 mit der Basis 12 herzustellen, insbesondere mit den in der Basis 12 angeordneten Kommunikationsleitungen 24.

Außerdem sind die Steckverbindungskomponenten 20 der Interaktionsmodule 16 jeweils dazu ausgebildet, zumindest eine elektrische Verbindung zur Basis 12 herzustellen, insbesondere zu den in der Basis 12 angeordneten elektrischen Leitern 26. Über die elektrischen Verbindungen können die auf die Basis 12 aufgesteckten Interaktionsmodule 16 bei Bedarf mit elektrischer Energie versorgt werden, insbesondere mit Spannungen im Kleinspannungsbereich.

Im Ausführungsbeispiel sind die Module 14, insbesondere die Interaktionsmodule 16, zusätzlich über Halteelemente 28 an der Basis 12 fixiert, um einen sicheren Halt zu gewährleisten. Die Halteelemente 28 sind in der gezeigten Ausführungsvariante durch Vorsprünge an den Ecken der jeweiligen Module 14 gebildet, die seitlich abstehen und in denen sich Öffnungen befinden. Zum Fixieren an der Basis 12 werden Befestigungselemente, beispielsweise Schrauben, in die jeweiligen Öffnungen eingesetzt und mit der Basis 12 befestigt, insbesondere verschraubt.

Die in Figur 1 dargestellten auf die Basis 12 aufgesteckten Interaktionsmodule 16 weisen jeweils ein Gehäuse 30 und eine darin angeordnete Elektronik 32 auf.

Die Gehäuse 30 sind jeweils durch einen Gehäusekörper 34 und einen auf den Gehäusekörper 34 angeordneten Gehäusedeckel 36 gebildet, der beispielsweise aufgesteckt ist. Die Gehäusedeckel 36 sind in der in Figur 1 gezeigten Variante zusätzlich mit Befestigungsmitteln 38 am Gehäusekörper 34 fixiert, beispielsweise mit Schrauben.

Die Steckverbindungskomponenten 20 sind jeweils am Gehäusekörper 34 angeordnet. Insbesondere sind die Steckverbindungskomponenten 20 und die Gehäusedeckel 36 an entgegengesetzten Seiten der jeweiligen Gehäuse 30 angeordnet.

Die in Figur 1 dargestellten auf die Basis 12 aufgesteckten Interaktionsmodule 16 umfassen außerdem jeweils zumindest ein Ausgabeelement 40, das im oder am Gehäuse 30 angeordnet und dazu ausgebildet ist, ein optisches Signal auszugeben, das einen Status der Industrieanlage signalisiert.

Die Ausgabeelemente 40 der Interaktionsmodule 16 weisen dazu jeweils zumindest eine Signalleuchte 42 auf, mittels der ein Betriebsstatus der Industrieanlage, eine Produktionsanweisung, ein Sicherheitshinweis und/oder ein Alarm für Arbeiter der Industrieanlage angezeigt werden kann. Beispielsweise kann die Signalausgabe durch Licht einer bestimmten Farbe oder ein Blinkmuster erfolgen.

Optional kann bei einem oder mehreren der Interaktionsmodule 16 zumindest ein Teil des Gehäuses 30 transparent oder transluzent ausgebildet und die Signalleuchte 42 innerhalb des Gehäuses 30 angeordnet sein, sodass Licht der Signalleuchte 42 über den transparent oder transluzent ausgebildeten Teil aus dem Gehäuse 30 auskoppeln kann.

Die Ausgabeelemente 40 der Interaktionsmodule 16 sind beispielsweise an Seitenwänden 44 der jeweiligen Gehäuse 30 oder im bzw. am Gehäusedeckel 36 angeordnet.

Die Signalleuchten 42 sind in den in Figur 1 gezeigten Interaktionsmodulen 16 jeweils als Flächenleuchten ausgebildet.

Die Signalleuchten 42 können gleichfarbig oder mehrfarbig ausgebildet und/oder in mehrere Segmente eingeteilt sein.

Insbesondere können die Signalleuchten 42 auch dazu ausgebildet sein, zur Signalausgabe Lichteffekte oder Symbole anzuzeigen.

Das Interaktionsmodul 16, das sich in der Mitte der Reihe befindet, weist eine Signalleichte 42 auf, die am Gehäusedeckel 36 angeordnet ist und 80% der Deckelfläche einnimmt. Dadurch können die ausgegebenen optischen Signale auch von weit entfernten Personen gut wahrgenommen werden. Dies ist selbstverständlich nicht einschränkend zu verstehen. Es sind auch Ausführungsvarianten denkbar, bei denen die Signalleuchte 42 100% der Deckelfläche einnimmt, wodurch eine besonders gute Sichtbarkeit erreicht wird. Es ist aber auch möglich, dass die Signalleuchte 42 nur 20% der Deckelfläche einnimmt. Signalleuchten 42 in diesem Größenbereich können beispielsweise als Markierungsschild dienen, insbesondere zum Kennzeichnen von Eingabeelementen 62.

Die Interaktionsmodule 16, die sich an den Enden der Reihe befinden, weisen jeweils zwei Signalleuchten 42 auf, von denen eine am Gehäusedeckel 36 und eine an einer Seitenwand 44 des Gehäuses 30 angeordnet ist. Auch diese Signalleuchten 42 erstrecken sich jeweils über mindestens 20%, vorzugsweise über 80%, der Deckelfläche bzw. Seitenfläche des Gehäuses 30. Durch diese Anordnung können mittels der Ausgabeelemente 40, wie in Figur 1 anhand von Pfeilen symbolisiert, optische Signale in unterschiedliche Raumrichtungen ausgesendet werden.

Die seitlichen Signalleuchten 42 der beiden an den Enden der Reihe angeordneten Interaktionsmodule 16 sind so zueinander angeordnet, dass sie optische Signale in entgegengesetzte Raumrichtungen ausgeben können. Dadurch wird der Kreis potenzieller Signalempfänger vergrößert.

Zumindest bei einem der Interaktionsmodule 16 ist das am Gehäusedeckel 36 angeordnete Ausgabeelement 40 mittels einer Flachbandleitung 48 und einem Steckkontakt 50 mit der im Gehäuse 30 angeordneten Elektronik 32 verbunden. Dadurch ist das Ausgabeelement 40 besonders einfach austauschbar, indem der Gehäusedeckel 36 abgenommen und der Steckkontakt 50 gelöst wird.

Figur 2 zeigt eine schematische Darstellung eines erfindungsgemäßen schaltschranklosen Automatisierungssystems 10 in einer zweiten Ausführungsform. Dieses entspricht im Wesentlichen der in Figur 1 gezeigten Variante, sodass nachfolgend lediglich auf die Unterschiede eingegangen wird. Gleiche oder funktionsgleiche Bauteile sind mit denselben Referenznummern gekennzeichnet.

Das in Figur 2 gezeigte schaltschranklose Automatisierungssystem 10 weist ein erfindungsgemäßes Interaktionsmodul 16 mit einem Ausgabeelement 40 auf. Das Ausgabeelement 40 umfasst ein Display 52, welches zur Signalausgabe zumindest ein Symbol 54 anzeigen kann. Im Vergleich zu der in Figur 1 gezeigten Variante wird dadurch die Anzahl der Signalisierungsmöglichkeiten erweitert.

Im Ausführungsbeispiel weist das Display 52 eine Hinterleuchtung 56 auf, deren Lichtfarbe zur Ausgabe des optischen Signals veränderbar ist. Beispielsweise kann das Display 52 rot hinterleuchtet sein, um einen Fehler oder eine Warnung auszugeben oder grün, um einen normalen Anlagenzustand zu signalisieren. Vorteilhaft an dieser Ausgestaltung ist, dass die Lichtfarbe auch für Personen in größeren Entfernungen noch wahrnehmbar ist und dadurch eine sehr große Signalreichweite realisiert werden kann.

Alternativ oder zusätzlich zum optischen Ausgabeelement 40 kann zur Signalausgabe auch zumindest ein akustisches Ausgabeelement 40 vorgesehen sein, beispielsweise ein Lautsprecher 58.

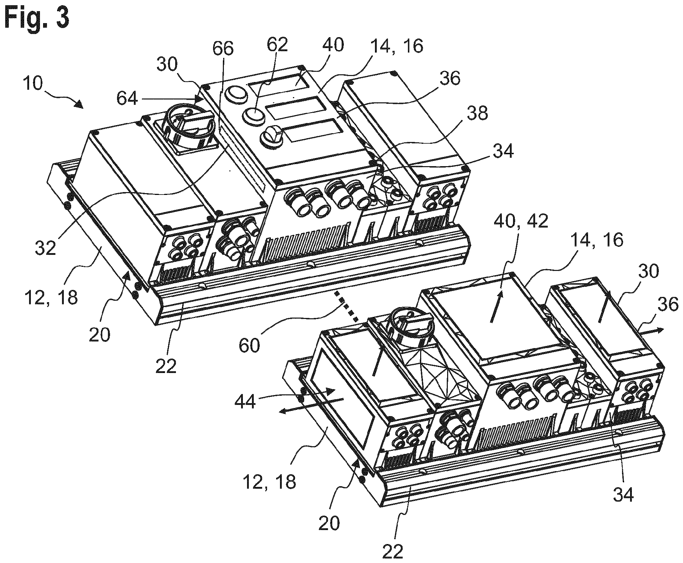

Figur 3 zeigt eine schematische Darstellung eines erfindungsgemäßen schaltschranklosen Automatisierungssystems 10 in einer dritten Ausführungsform. Dieses entspricht im Wesentlichen den in Figur 1 und Figur 2 gezeigten Varianten, sodass nachfolgend wieder lediglich auf die Unterschiede eingegangen wird. Gleiche oder funktionsgleiche Bauteile sind mit denselben Referenznummern gekennzeichnet.

Das in Figur 3 gezeigte schaltschranklose Automatisierungssystem 10 umfasst eine weitere Basis 12 mit Interaktionsmodulen 16.

Die Basen 12 sind voneinander beabstandet angeordnet und über einen Datenanschluss 60 miteinander gekoppelt, sodass mittels der auf den verschiedenen Basen 12 angeordneten Interaktionsmodulen 16 voneinander abhängige und/oder aufeinander abgestimmte optische und/oder akustische Signale an unterschiedlichen Positionen der Industrieanlage ausgegeben werden können.

Eines der in Figur 3 dargestellten Interaktionsmodule 16 weist mehrere manuell betätigbare Eingabeelemente 62 auf, worüber manuelle Eingaben zur Steuerung der Industrieanlage erfolgen können.

Die Eingabeelemente 62 sind auf einer Leiterplatte 64 angeordnet und durch einen Bus 66 mit der im Gehäuse 30 angeordneten Elektronik 32 verbunden.

Selbstverständlich können in einem Interaktionsmodul 16 auch mehrere Eingabeelemente 62 und Ausgabeelemente 40 vorgesehen sein, die beispielsweise auf einer gemeinsamen Leiterplatte 64 angeordnet sind.

Dies ermöglicht sowohl die Ausgabe von Signalen unmittelbar aus dem Interaktionsmodul 16 bzw. dem schaltschranklose Automatisierungssystem 10 als auch die direkte Eingabe von Befehlen.

Die in den Figuren gezeigten Ausführungsbeispiele sind nicht einschränkend zu verstehen, sondern verdeutlichen beispielhafte Ausführungsformen der Erfindung.

## Patentansprüche

1. Interaktionsmodul für ein schaltschrankloses Automatisierungssystem (10) einer Industrieanlage, umfassend ein Gehäuse (30) und eine Steckverbindungskomponente (20) zur elektrischen und/oder mechanischen Anbindung an eine Basis (12) des schaltschranklosen Automatisierungssystems (10) und wobei das Interaktionsmodul (16) ein Ausgabeelement (40) umfasst, das im oder am Gehäuse (30) angeordnet und dazu ausgebildet ist, ein optisches und/oder akustisches Signal auszugeben, das einen Status der Industrieanlage signalisiert, und/oder wobei das Interaktionsmodul (16) ein Eingabeelement (62) aufweist, das im oder am Gehäuse (30) angeordnet ist und worüber eine Eingabe zur Steuerung der Industrieanlage erfolgen kann.

2. Interaktionsmodul gemäß Anspruch 1, wobei das Gehäuse (30) durch einen Gehäusekörper (34) und einen Gehäusedeckel (36) gebildet ist, und wobei das Ausgabeelement (40) und/oder das Eingabeelement (62) im oder am Gehäusedeckel (36) angeordnet ist, insbesondere wobei die Steckverbindungskomponente (20) am Gehäusekörper (34) angeordnet ist.

3. Interaktionsmodul nach Anspruch 2, wobei der Gehäusedeckel (36) auf den Gehäusekörper (34) aufgesteckt und/oder am Gehäusekörper (34) mit einem Befestigungsmittel (38) befestigt ist, und wobei das Ausgabeelement (40) und/oder das Eingabeelement (62) durch einen Steckkontakt (50) und/oder eine Flachbandleitung (48) mit einer im Gehäuse (30) aufgenommenen Elektronik (32) verbunden ist.

4. Interaktionsmodul gemäß einem der vorhergehenden Ansprüche, wobei das Ausgabeelement (40) zumindest eine Signalleuchte (42) umfasst, die dazu ausgebildet ist, einen Betriebsstatus, eine Produktionsanweisung, einen Sicherheitshinweis und/oder einen Alarm für Arbeiter der Industrieanlage auszugeben.

5. Interaktionsmodul gemäß Anspruch 4, wobei die Signalleuchte (42) eine Flächenleuchte ist, die sich über einen Teil einer Seite des Gehäuses (30) erstreckt, insbesondere über zumindest 20 %, beispielsweise über mehr als 50 %, z.B. über mehr als 80 % der Seitenfläche.

6. Interaktionsmodul gemäß Anspruch 4 oder 5, wobei zumindest ein Teil des Gehäuses (30) transparent oder transluzent ausgebildet ist, sodass Licht der Signalleuchte (42) über den Teil des Gehäuses (30) aus dem Gehäuse (30) auskoppeln kann.

7. Interaktionsmodul gemäß einem der Ansprüche 4 bis 6, umfassend zumindest eine weitere Signalleuchte (42), wobei die Signalleuchten (42) an unterschiedlichen Seiten des Gehäuses (30) angeordnet sind, sodass die Signalleuchten (42) Licht in unterschiedliche Raumrichtungen ausstrahlen.

8. Interaktionsmodul gemäß einem der vorhergehenden Ansprüche, wobei das Ausgabeelement (40) zumindest ein Display (52) umfasst, das dazu ausgebildet ist, zur Signalausgabe zumindest ein Symbol (54) anzuzeigen.

9. Interaktionsmodul gemäß Anspruch 8, wobei das Display (52) eine Hinterleuchtung (56) umfasst, insbesondere wobei eine Lichtfarbe der Hinterleuchtung (56) zur Ausgabe des optischen Signals veränderbar ist.

10. Interaktionsmodul gemäß einem der vorhergehenden Ansprüche, wobei das Eingabeelement (62) ein manuell zu betätigendes Eingabeelement (62) ist, insbesondere wobei das Eingabeelement (62) zusammen mit mehreren weiteren Eingabeelementen (62) auf einer Leiterplatte (64) angeordnet ist, wobei die Eingabeelemente (62) durch einen Bus (66) mit einer im Gehäuse (30) angeordneten Elektronik (32) verbunden sind.

11. Schaltschrankloses Automatisierungssystem für eine Industrieanlage, umfassend eine Basis (12) und zumindest ein Interaktionsmodul (16) gemäß einem der vorhergehenden Ansprüche, wobei das Interaktionsmodul (16) über die Steckverbindungskomponente (20) mit der Basis (12) elektrisch und/oder mechanisch verbunden ist.

12. Schaltschrankloses Automatisierungssystem nach Anspruch 11, wobei die Basis (12) als eine Steckplatte (18) zur Aufnahme des Interaktionsmoduls (16) sowie weiterer steckbarer Module (14) ausgebildet ist.

13. Schaltschrankloses Automatisierungssystem nach Anspruch 11 oder 12, wobei die Basis (12) mehrere Kommunikationsleitungen (24) sowie Leiter (26) zum Führen einer Niederspannung und/oder Leiter (26) zum Führen einer Kleinspannung aufweist und wobei die Steckverbindungskomponente (20) dazu ausgebildet ist, eine Datenverbindung zwischen dem Interaktionsmodul (16) und den Kommunikationsleitungen (24) der Basis (12) herzustellen und/oder eine elektrische Verbindung zu den klein- und/oder niederspannungsführenden Leitern (26) der Basis (12) herzustellen, wenn das Interaktionsmodul (16) auf die Basis (12) aufgesteckt bzw. in die Basis (12) eingesteckt ist.

14. Schaltschrankloses Automatisierungssystem nach einem der Ansprüche 11 bis 13, umfassend ein weiteres Interaktionsmodul (16) gemäß einem der Ansprüche 1 bis 10, wobei die Interaktionsmodule (16) an entgegengesetzten Enden der Basis (12) angeordnet sind, insbesondere wobei die Interaktionsmodule (16) jeweils äußerste Module (14) einer entlang der Basis (12) angeordneten Reihe von Modulen (14) bilden.

15. Schaltschrankloses Automatisierungssystem nach einem der Ansprüche 11 bis 14, umfassend zumindest eine weitere Basis (12) mit einem Interaktionsmodul (16) gemäß einem der Ansprüche 1 bis 10, wobei die Basen (12) voneinander beabstandet angeordnet und über einen Datenanschluss (60) gekoppelt sind, sodass mittels der auf den verschiedenen Basen (12) angeordneten Interaktionsmodulen (16) voneinander abhängige und/oder aufeinander abgestimmte optische und/oder akustische Signale an unterschiedlichen Positionen der Industrieanlage ausgegeben werden können.

## Geänderte Patentansprüche

### Geänderte Patentansprüche gemäss Regel 137(2) EPÜ.

1. Interaktionsmodul für ein schaltschrankloses Automatisierungssystem (10) einer Industrieanlage, umfassend ein Gehäuse (30) und eine Steckverbindungskomponente (20) zur elektrischen und mechanischen Anbindung an eine Basis (12) des schaltschranklosen Automatisierungssystems (10), wobei das Interaktionsmodul (16) ein Ausgabeelement (40) umfasst, das im oder am Gehäuse (30) angeordnet und dazu ausgebildet ist, ein optisches und/oder akustisches Signal auszugeben, das einen Status der Industrieanlage signalisiert, wobei das Interaktionsmodul (16) ein Eingabeelement (62) aufweist, das im oder am Gehäuse (30) angeordnet ist und worüber eine Eingabe zur Steuerung der Industrieanlage erfolgen kann, wobei das Gehäuse (30) durch einen Gehäusekörper (34) und einen Gehäusedeckel (36) gebildet ist, wobei zumindest das Ausgabeelement (40) im oder am Gehäusedeckel (36) angeordnet ist, und wobei die Steckverbindungskomponente (20) am Gehäusekörper (34) auf einer zum Gehäusedeckel (36) entgegengesetzten Seite des Gehäuses (30) angeordnet ist.

2. Interaktionsmodul nach Anspruch 1, wobei der Gehäusedeckel (36) auf den Gehäusekörper (34) aufgesteckt und/oder am Gehäusekörper (34) mit einem Befestigungsmittel (38) befestigt ist, und wobei das Ausgabeelement (40) und/oder das Eingabeelement (62) durch einen Steckkontakt (50) und/oder eine Flachbandleitung (48) mit einer im Gehäuse (30) aufgenommenen Elektronik (32) verbunden ist.

3. Interaktionsmodul gemäß Anspruch 1 oder 2, wobei das Ausgabeelement (40) zumindest eine Signalleuchte (42) umfasst, die dazu ausgebildet ist, einen Betriebsstatus, eine Produktionsanweisung, einen Sicherheitshinweis und/oder einen Alarm für Arbeiter der Industrieanlage auszugeben.

4. Interaktionsmodul gemäß Anspruch 3, wobei die Signalleuchte (42) eine Flächenleuchte ist, die sich über einen Teil einer Seite des Gehäuses (30) erstreckt, insbesondere über zumindest 20 %, beispielsweise über mehr als 50 %, z.B. über mehr als 80 % der Seitenfläche.

5. Interaktionsmodul gemäß Anspruch 3 oder 4, wobei zumindest ein Teil des Gehäuses (30) transparent oder transluzent ausgebildet ist, sodass Licht der Signalleuchte (42) über den Teil des Gehäuses (30) aus dem Gehäuse (30) auskoppeln kann.

6. Interaktionsmodul gemäß einem der Ansprüche 3 bis 5, umfassend zumindest eine weitere Signalleuchte (42), wobei die Signalleuchten (42) an unterschiedlichen Seiten des Gehäuses (30) angeordnet sind, sodass die Signalleuchten (42) Licht in unterschiedliche Raumrichtungen ausstrahlen.

7. Interaktionsmodul gemäß einem der vorhergehenden Ansprüche, wobei das Ausgabeelement (40) zumindest ein Display (52) umfasst, das dazu ausgebildet ist, zur Signalausgabe zumindest ein Symbol (54) anzuzeigen.

8. Interaktionsmodul gemäß Anspruch 7, wobei das Display (52) eine Hinterleuchtung (56) umfasst, insbesondere wobei eine Lichtfarbe der Hinterleuchtung (56) zur Ausgabe des optischen Signals veränderbar ist.

9. Interaktionsmodul gemäß einem der vorhergehenden Ansprüche, wobei das Eingabeelement (62) ein manuell zu betätigendes Eingabeelement (62) ist, insbesondere wobei das Eingabeelement (62) zusammen mit mehreren weiteren Eingabeelementen (62) auf einer Leiterplatte (64) angeordnet ist, wobei die Eingabeelemente (62) durch einen Bus (66) mit einer im Gehäuse (30) angeordneten Elektronik (32) verbunden sind.

10. Schaltschrankloses Automatisierungssystem für eine Industrieanlage, umfassend eine Basis (12) und zumindest ein Interaktionsmodul (16) gemäß einem der vorhergehenden Ansprüche, wobei das Interaktionsmodul (16) über die Steckverbindungskomponente (20) mit der Basis (12) elektrisch und/oder mechanisch verbunden ist.

11. Schaltschrankloses Automatisierungssystem nach Anspruch 10, wobei die Basis (12) als eine Steckplatte (18) zur Aufnahme des Interaktionsmoduls (16) sowie weiterer steckbarer Module (14) ausgebildet ist.

12. Schaltschrankloses Automatisierungssystem nach Anspruch 10 oder 11, wobei die Basis (12) mehrere Kommunikationsleitungen (24) sowie Leiter (26) zum Führen einer Niederspannung und/oder Leiter (26) zum Führen einer Kleinspannung aufweist und wobei die Steckverbindungskomponente (20) dazu ausgebildet ist, eine Datenverbindung zwischen dem Interaktionsmodul (16) und den Kommunikationsleitungen (24) der Basis (12) herzustellen und/oder eine elektrische Verbindung zu den klein- und/oder niederspannungsführenden Leitern (26) der Basis (12) herzustellen, wenn das Interaktionsmodul (16) auf die Basis (12) aufgesteckt bzw. in die Basis (12) eingesteckt ist.

13. Schaltschrankloses Automatisierungssystem nach einem der Ansprüche 10 bis 12, umfassend ein weiteres Interaktionsmodul (16) gemäß einem der Ansprüche 1 bis 9, wobei die Interaktionsmodule (16) an entgegengesetzten Enden der Basis (12) angeordnet sind, insbesondere wobei die Interaktionsmodule (16) jeweils äußerste Module (14) einer entlang der Basis (12) angeordneten Reihe von Modulen (14) bilden.

14. Schaltschrankloses Automatisierungssystem nach einem der Ansprüche 10 bis 13, umfassend zumindest eine weitere Basis (12) mit einem Interaktionsmodul (16) gemäß einem der Ansprüche 1 bis 9, wobei die Basen (12) voneinander beabstandet angeordnet und über einen Datenanschluss (60) gekoppelt sind, sodass mittels der auf den verschiedenen Basen (12) angeordneten Interaktionsmodulen (16) voneinander abhängige und/oder aufeinander abgestimmte optische und/oder akustische Signale an unterschiedlichen Positionen der Industrieanlage ausgegeben werden können.
